# EUROPÄISCHE PATENTANMELDUNG

(11) **EP 0 645 956 A1**
(43) Veröffentlichungstag der Anmeldung: **29.03.1995**
(21) Anmeldenummer: 94113979.2
(22) Anmeldetag: 07.09.1994
(51) Int. Cl.: H05K 7/18

(54) **Gestellrahmen**

(30) Priorität: 28.09.1993 DE 4333026
(71) Anmelder: Rittal-Werk Rudolf Loh GmbH & Co. KG, D-35745 Herborn (DE)
(72) Erfinder: Besserer, Horst, D-35745 Herborn (DE); Bovermann, Klaus-Dieter, D-35236 Breidenbach-Niederdieten (DE); Hartel, Marc, D-35477 Reiskirchen (DE)
(74) Vertreter: Fleck, Hermann-Josef, Dr.-Ing.

(57) **Zusammenfassung**

Die Erfindung betrifft einen Gestellrahmen mit vertikalen Trägern, wobei an den vorderen beiden Trägern Halterungen mit einem vertikal zur Vorderseite des Gestellrahmens verlaufenden Schenkel und einem rechtwinklig hierzu stehenden Befestigungsansatz anordenbar sind und wobei die Befestigungsansätze der Halterungen einander zugekehrt sind und Befestigungsaufnahmen aufweisen, an denen in das Innere des Gestellrahmens ragende Einbauten befestigbar sind. Einbauten mit verschiedenen Einbautiefen können auf einfache Weise mit ihren Rückseiten in eine gemeinsame Anschlußebene gebracht und gleichzeitig sicher an den vorderen Trägern befestigt werden, wenn vorgesehen ist, daß die Befestigungsansätze der Halterungen an den vorderen Trägern in Richtung der Tiefe des Gestellrahmens verstell- und arretierbar sind.

## Beschreibung

Die Erfindung betrifft einen Gestellrahmen mit vertikalen Trägern, wobei an den vorderen beiden Trägern Halterungen mit einem vertikal zur Vorderseite des Gestellrahmens verlaufenden Schenkel und einem rechtwinklig hierzu stehenden Befestigungsansatz anordenbar sind und wobei die Befestigungsansätze der Halterungen einander zugekehrt sind und Befestigungsaufnahmen aufweisen, an denen in das Innere des Gestellrahmens ragende Einbauten befestigbar sind.

Bei derartigen Gestellrahmen sind die beiden vorderen Träger über ihre gesamte Länge mit einer als Winkelleiste ausgebildeten Halterung verbunden. An den Winkelstücken sind Einbauten, beispielsweise Baugruppenträger, befestigbar. Werden mehrere Baugruppenträger mit verschiedener Einbautiefe an den Winkelleisten befestigt, so ist mit den rückseitigen Anschlußwänden der einzelnen Baugruppenträger keine gemeinsame Anschlußebene gebildet. Für die Kontaktierung ergibt sich damit ein hoher Aufwand, da für jeden Baugruppenträger eine individuelle Kontaktanordnung, passend zu der jeweiligen Einbautiefe, am Gestellrahmen befestigt werden muß. Dieses Problem tritt häufig bei der Verwendung genormter Baugruppenträger auf, von denen einige in Zollteilung und andere in metrischer Teilung ausgebildet sind.

Es ist daher Aufgabe der Erfindung, einen Gestellrahmen der eingangs erwähnten Art zu schaffen, an dem Einbauten mit verschiedener Einbautiefe auf einfache Art so befestigt werden können, daß sie eine gemeinsame rückseitige Anschlußebene bilden.

Die Aufgabe der Erfindung wird dadurch gelöst, daß die Befestigungsansätze der Halterungen an den vorderen Trägern in Richtung der Tiefe des Gestellrahmens verstell- und arretierbar sind.

Mittels der verstellbaren Befestigungsansätze können die einzelnen Einbauten in Richtung der Tiefe des Gestellrahmens so verschoben werden, daß sie rückseitig eine gemeinsame Anschlußebene bilden. Dabei kann die Verstellbarkeit so ausgebildet sein, daß sie entweder stufenlos oder gerastert in Teilschritten möglich ist. Einbauten mit gleicher Einbautiefe können an einer Halterung angebracht sein. Sollen beispielsweise mehrere Baugruppenträger, die in Zollteilung ausgebildet sind, mit solchen Baugruppenträgern, die in metrischer Teilung ausgebildet sind, in einem Gestellrahmen eingebaut werden, dann werden zwei Halterungen übereinander an den vorderen Trägern angebracht. An den Halterungen werden dann jeweils die unterschiedlichen Baugruppenträger befestigt und können im Gestellrahmen in eine Position gebracht werden, in der die rückseitigen Anschlußwände sowohl der in metrischer, als auch der in Zollteilung ausgebildeten Baugruppenträger eine gemeinsame Anschlußebene bilden.

Die Verstell- und Arretierbarkeit der Befestigungsansätze in Richtung der Tiefe des Gestellrahmens bietet auch Vorteile in der optimalen Ausnutzung des Raumes im vorderen Bereich des Gestellrahmens. Zum Beispiel lassen sich größere Bedienelemente, die in der Tiefe stark auftragen, noch plazieren.

Nach einer vorteilhaften Ausgestaltung der Erfindung ist vorgesehen, daß der Befestigungsansatz und der Schenkel einstückig ein Winkelstück bilden und daß der Schenkel des Winkelstückes in einer Aufnahme des vorderen Trägers festlegbar und in dieser verschiebbar ist. Damit ist die Halterung als Halbzeug einfach herstellbar und kann entsprechend abgelängt werden. Die Aufnahme stützt den Schenkel ab, so daß der Befestigungsansatz stets parallel zur Vorderseite des Gestellrahmens ausgerichtet ist.

Ist vorgesehen, daß die Aufnahmen an den einander zugekehrten Innenseiten der vorderen Träger als Absätze ausgebildet sind, die zur Vorderseite hin in einen Anschlag übergehen, dann kann der vordere Träger als einfaches Teil ausgebildet sein. Der Anschlag legt die Halterung in einer Ausgangsstellung fest, von der aus sie um das gewünschte Maß verschoben werden kann.

Eine bevorzugte Ausgestaltung eines Gestellrahmens ist dadurch gekennzeichnet, daß der vordere Träger einen längsgerichteten Haltesteg aufweist, an dem ein U-förmiges Befestigungselement längs verschiebbar ist und daß in den Schenkel der Halterung ein in Richtung der Tiefe des Gestellrahmens verlaufendes Langloch eingebracht ist, in das eine Befestigungsschraube einführbar und mit einer Gewindeaufnahme des Befestigungselementes verschraubbar ist. Das U-förmige Befestigungselement kann einfach mit dem Haltesteg verbunden, beispielsweise aufgeklipst, werden. An dem Haltesteg können die Befestigungselemente stufenlos in Richtung der Höhe des Gestellrahmens an den vorderen Trägern verschoben werden. Damit können auch die Halterungen stufenlos verstellt werden, so daß die Einbauhöhe der Einbauten frei einstellbar ist.

Ist vorgesehen, daß der Haltesteg gegenüber der Außenseite des vorderen Trägers parallel nach innen versetzt ist und sich an den Absatz des vorderen Trägers anschließt, dann kann die Halterung beabstandet zur Außenseite des Gestellrahmens befestigt werden. Somit können an den Trägern Seitenwände angebracht werden, mittels derer der Gestellrahmen verschließbar ist. Die Verstellmöglichkeit der Halterungen bleibt dadurch unbeeinflußt.

Eine vorteilhafte Ausgestaltung des Befestigungselementes ist dadurch gekennzeichnet, daß das Befestigungselement zwei den Haltesteg beidseitig übergreifende Schenkel aufweist, von denen der dem Winkelstück abgekehrte Schenkel die Gewindeaufnahme und der dem Winkelstück zugekehrte Schenkel eine hierzu fluchtende Schraubenaufnahme aufweisen.

Die einfache Anbringung des Befestigungselementes an dem Haltesteg und die gut zugängliche Befestigung der Halterung ist dann möglich, wenn vorgesehen ist, daß die Schenkel des Befestigungselementes zur Vorderseite des Gestellrahmens hin gerichtet sind.

Ist ein Gestellrahmen dadurch gekennzeichnet, daß das Winkelstück mit seinem Schenkel auf einer Tiefenstrebe aufgeschraubt ist und daß die Tiefenstrebe mit einem Halteansatz an dem vorderen Träger befestigt ist, dann ermöglicht die Tiefenstrebe auch den Einbau von beispielsweise Baugruppenträgern mit nur geringer Einbautiefe. Dabei können die Tiefenstreben sich als Führung auch über die gesamte Tiefe des Gestellrahmens erstrecken. Sie sind dann vorzugsweise auch an den hinteren vertikalen Trägern befestigt. Damit können auch Einbauten mit hohem Gewicht sicher festgelegt und geführt werden.

Dabei ist es auch möglich, daß der Halteansatz der Tiefenstrebe mittels des Befestigungselementes an dem Haltesteg des vorderen Trägers festlegbar ist. Die Tiefenstrebe ist somit auch in der Höhe des Gestellrahmens stufenlos verstellbar.

Die Erfindung wird im folgenden anhand von in den Zeichnungen dargestellten Ausführungsbeispielen näher erläutert. Es zeigen:
- Fig. 1: in perspektivischer Darstellung einen Abschnitt eines vorderen und eines hinteren vertikalen Träger eines Gestellrahmens, an denen eine Seitenwand sowie eine Rückwand befestigt ist,
- Fig. 2: in Draufsicht den vorderen Träger nach Fig. 1 mit einer Halterung, und
- Fig. 3: in Draufsicht den vorderen Träger nach Fig. 1 mit einer Tiefenstrebe.

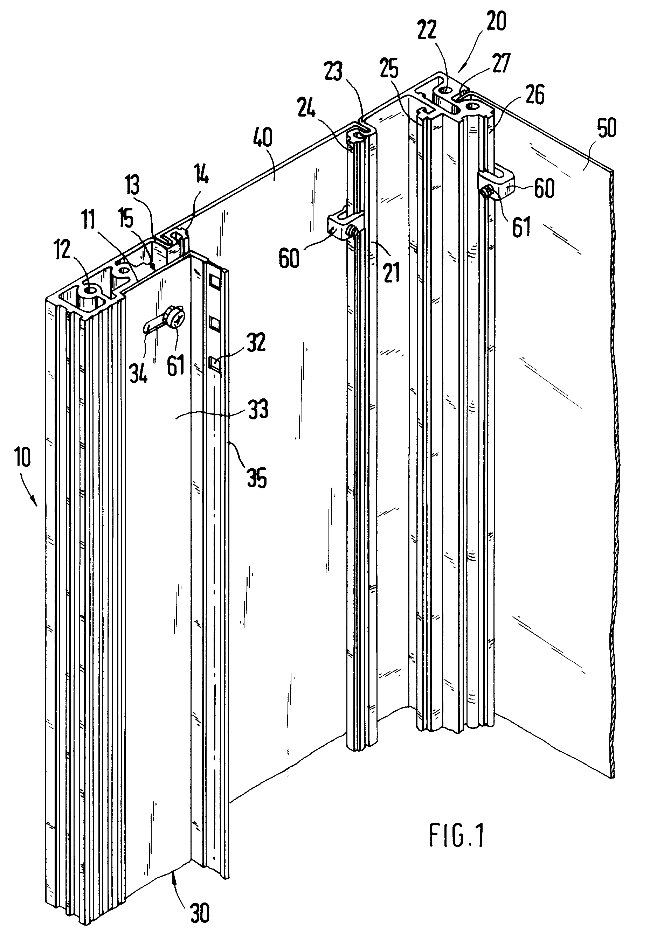

In Fig. 1 ist ein Teil eines Gestellrahmens mit einem vorderen und einem hinteren vertikalen Träger 10 und 20 dargestellt. Der Gestellrahmen ist mittels Seitenwänden 40 und einer Rückwand 50 verschließbar. Hierzu sind an den Trägern 10, 20 längsgerichtete Klemmstege 14,16, 26 angebracht. An den Klemmstegen 14,16, 26 sind Befestigungselemente 60 angebracht und an diesen in Richtung der Höhe des Gestellrahmens verschiebbar. Damit können die Befestigungselemente 60 soweit verschoben werden, bis sie hinter einer Schraubenaufnahme der Seitenwand 40 oder der Rückwand 50 zum liegen kommen.

In die Schraubenaufnahme ist dann eine Befestigungsschraube einführbar und mit dem Befestigungselement 60 verschraubbar. Hierbei verspannt sich das Befestigungselement 60 an dem Klemmsteg 14,24, 26. Die Seitenwände 40 und die Rückwand 50 weisen Abkantungen auf, die in Aufnahmeschlitze 13,23, 27 der Träger 10,20 eingesetzt sind. Auf den Gestellrahmen ist ein Deckel aufsetzbar. Der Deckel kann mittels Befestigungsschrauben, die in die längsgerichteten Schraubkanäle 12, 22 der Träger 10,20 einschraubbar sind, festgelegt werden.

An dem vorderen Träger 10 ist eine Halterung 30 angebracht Die Halterung 30 ist als Winkelstück ausgebildet, das aus einem Schenkel 33 besteht, an dem rechtwinklig ein Befestigungsansatz 35 angeformt ist. Der Befestigungsansatz 35 verläuft parallel zur Vorderseite des Gestellrahmens und ist mit einer Reihe von in gleicher Teilung eingebrachten Befestigungsaufnahmen 32 versehen. Die Befestigungsansätze 35 der an den vorderen Trägern 10 befestigten Halterungen 30 sind einander zugekehrt.

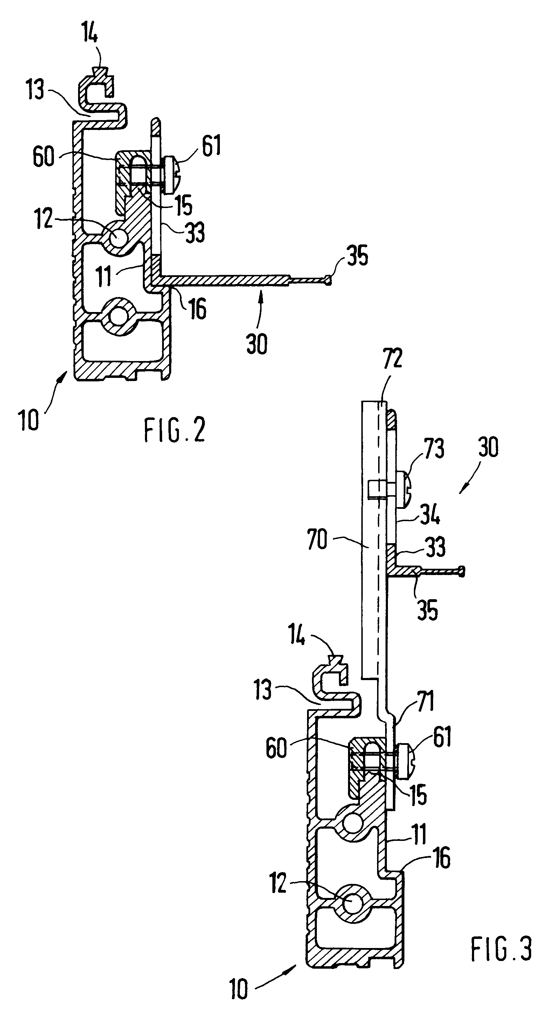

An den Befestigungsaufnahmen 32 können in das Innere des Gestellrahmens ragende Einbauten befestigt werden. Die Halterung 30 ist mit in Richtung der Schranktiefe verlaufenden Langlöchern 34 versehen. In die Langlöcher 34 sind Befestigungsschrauben 61 eingesetzt und mit Befestigungselementen 60 verschraubt, wie das die Fig. 2 deutlicher zeigt. In dieser Darstellung ist der vordere Träger 10 in Draufsicht dargestellt. Die Halterung 30 ist mit dem Schenkel 33 in eine Aufnahme 11 des vorderen Trägers 10 eingesetzt. Die Aufnahmen 11 sind an den einander zugekehrten Innenseiten der vorderen Träger 10 als Absätze ausgebildet, die zur Vorderseite hin in einen Anschlag 16 übergehen.

Rückseitig geht der Absatz in einen längsgerichteten Haltesteg 15 über. Auf den Haltesteg 15 ist das Befestigungselement 60 aufgeklipst. Das Befestigungselement 60 weist zwei parallele Schenkel auf, von denen der der Halterung 30 abgekehrte Schenkel eine Gewindeaufnahme trägt. Der der Halterung 30 zugekehrte Schenkel weist zur Gewindeaufnahme fluchtend eine Schraubenaufnahme auf. Die Befestigungsschraube 61 ist in das Langloch 34 der Halterung und in die Schraubenaufnahme des einen Schenkels eingeführt und in der Gewindeaufnahme des anderen Schenkels verschraubt. Damit werden die beiden Schenkel des Befestigungselementes 60 am Haltesteg 15 verspannt und die Halterung 30 am vorderen Träger 10 festgelegt. Wird die Befestigungsschraube 61 wieder gelöst, dann kann der Befestigungsansatz 35 mittels des Langloches 34 in Richtung der Tiefe des Gestellrahmens und zum anderen die Halterung 30 stufenlos in Richtung der Höhe des Gestellrahmens am vorderen Träger 10 verstellt werden.

In Fig. 3 ist eine weitere Ausführungsform einer erfindungsgemäßen Halterung 30 gezeigt. Die Halterung 30 ist hierbei aus einer Tiefenstrebe 70 und einem Winkelstück zusammengesetzt. Die Tiefenstrebe 70 weist an ihrer, dem vorderen Träger 10 zugekehrten Seite einen Halteansatz 71 auf, in den eine Schraubenaufnahme eingebracht ist. Die Tiefenstrebe 70 ist mit dem vorderen Träger 10 in der oben geschilderten Weise mit den Befestigungselementen 60 und der Befestigungsschraube 61 verbindbar. Somit kann die Tiefenstrebe 70 in Richtung der Höhe des Gestellrahmens stufenlos verstellt werden.

Auf der Tiefenstrebe 70 ist das Winkelstück mit dem Schenkel 33 befestigt und kann mittels des Langloches 34 und der Befestigungsschraube 61 hieran stufenlos verstellt werden.

In die Tiefenstrebe 70 sind zueinander versetzt in gleicher Teilung Gewindeaufnahmen eingebracht, in die die Befestigungsschraube 61 einschraubbar ist. Damit ist über die gesamte Länge der Tiefenstrebe 70 mit dem Winkelstück eine Verstellmöglichkeit geschaffen worden.

## Patentansprüche

1. Gestellrahmen mit vertikalen Trägern, wobei an den vorderen beiden Trägern Halterungen mit einem vertikal zur Vorderseite des Gestellrahmens verlaufenden Schenkel und einem rechtwinklig hierzu stehenden Befestigungsansatz anordenbar sind und wobei die Befestigungsansätze der Halterungen einander zugekehrt sind und Befestigungsaufnahmen aufweisen, an denen in das Innere des Gestellrahmens ragende Einbauten befestigbar sind,
dadurch gekennzeichnet,
daß die Befestigungsansätze (35) der Halterungen (30) an den vorderen Trägern (10) in Richtung der Tiefe des Gestellrahmens verstell- und arretierbar sind.

2. Gestellrahmen nach Anspruch 1,
dadurch gekennzeichnet,
daß der Befestigungsansatz (35) und der Schenkel (33) einstückig ein Winkelstück bilden und
daß der Schenkel (33) des Winkelstückes in einer Aufnahme (11) des vorderen Trägers (10) festlegbar und in dieser verschiebbar ist.

3. Gestellrahmen nach Anspruch 2,
dadurch gekennzeichnet,
daß die Aufnahmen (11) an den einander zugekehrten Innenseiten der vorderen Träger (10) als Absätze ausgebildet sind, die zur Vorderseite hin in einen Anschlag (16) übergehen.

4. Gestellrahmen nach einem der Ansprüche 1 bis 3,
dadurch gekennzeichnet,
daß der vordere Träger (10) einen längsgerichteten Haltesteg (15) aufweist, an dem ein U-förmiges Befestigungselement (60) längs verschiebbar ist und
daß in den Schenkel (33) der Halterung (30) ein in Richtung der Tiefe des Gestellrahmens verlaufendes Langloch (34) eingebracht ist, in das eine Befestigungsschraube (61) einführbar und mit einer Gewindeaufnahme des Befestigungselementes (60) verschraubbar ist.

5. Gestellrahmen nach Anspruch 4,
dadurch gekennzeichnet,
daß der Haltesteg (15) gegenüber der Außenseite des vorderen Trägers (10) parallel nach innen versetzt ist und sich an den Absatz des vorderen Trägers (10) anschließt.

6. Gestellrahmen nach Anspruch 4 oder 5,
dadurch gekennzeichnet,
daß das Befestigungselement (60) zwei den Haltesteg (15) beidseitig übergreifende Schenkel aufweist, von denen der dem Winkelstück abgekehrte Schenkel die Gewindeaufnahme und der dem Winkelstück zugekehrte Schenkel eine hierzu fluchtende Schraubenaufnahme aufweist.

7. Gestellrahmen nach einem der Ansprüche 4 bis 6,
dadurch gekennzeichnet,
daß die Schenkel des Befestigungselementes (60) zur Vorderseite des Gestellrahmens hin gerichtet sind.

8. Gestellrahmen nach einem der Ansprüche 1 bis 7,
dadurch gekennzeichnet,
daß das Winkelstück mit seinem Schenkel (33) auf einer Tiefenstrebe (70) aufgeschraubt ist und
daß die Tiefenstrebe (70) mit einem Halteansatz (71) an dem vorderen Träger (10) befestigt ist.

9. Gestellrahmen nach Anspruch 8,
dadurch gekennzeichnet,
daß der Halteansatz (71) der Tiefenstrebe (70) mittels des Befestigungselementes (60) an dem Haltesteg (15) des vorderen Trägers (10) festlegbar ist.
